# EUROPEAN PATENT APPLICATION

(11) **EP 4 852 643 A1**
(43) Date of publication of application: **09.12.2026**
(21) Application number: 26162601.4
(22) Date of filing: 05.03.2026
(51) Int. Cl.: H10B 12/00, H10D 1/68, H10D 30/67

(54) **SEMICONDUCTOR DEVICE INCLUDING SUPPORT STRUCTURE**

(30) Priority: 05.06.2025 KR 20250073476
(71) Applicant: Samsung Electronics Co., Ltd., Suwon-si, Gyeonggi-do 16677 (KR)
(72) Inventor: HAN, Sang-Il, 16677 Suwon-si (KR); BAE, Taejin, 16677 Suwon-si (KR); OH, Gyuhwan, 16677 Suwon-si (KR); HAN, Jinwoo, 16677 Suwon-si (KR)
(74) Representative: Marks & Clerk LLP

(57) **Abstract**

A semiconductor device includes first semiconductor patterns extending in a first direction on a substrate and spaced apart from each other in a second direction, second semiconductor patterns spaced apart from the first semiconductor patterns in the first direction, first word lines extending in a third direction, second word lines extending in the third direction, a capacitor structure including first bottom electrodes and second bottom electrodes, and a dielectric layer covering the first and second bottom electrodes, and a support structure on the upper surface of the substrate and including a first supporter layer extending in the second direction, and including a first portion on a side surface of the first word lines and partially overlapping the first bottom electrodes in the third direction, and a second portion disposed on a side surface of the second word lines and partially overlapping the second bottom electrodes in the third direction.

## Description

### BACKGROUND

### 1. Field

The present disclosure relates to a semiconductor device including a support structure.

### 2. Description of Related Art

A semiconductor device refers to a core component used to control or amplify electrical signals in an electronic device, and various types of semiconductor devices may be manufactured. For example, a semiconductor memory device may be mainly used for storing and retrieving data. The semiconductor memory device is a key element of electronic devices, playing an essential role in various fields such as computers, communication equipment, and consumer electronics.

As industry develops, the demands for the performance and functionality of electronic devices are increasing further. Accordingly, high performance is essentially required for semiconductor memory devices, and to meet these demands, the integration density of semiconductor memory devices is continuously increasing. In this development process, new transistor structures such as a transistor having a vertical channel and a vertical stack transistor have been proposed.

### SUMMARY

Provided is a semiconductor device which may have improved mechanical reliability.

According to an aspect of the disclosure, a semiconductor device includes: a substrate; first semiconductor patterns extending in a first direction on an upper surface of the substrate, the first semiconductor patterns being stacked on and spaced apart from each other in a second direction intersecting the first direction; second semiconductor patterns spaced apart from the first semiconductor patterns in the first direction; first word lines extending in a third direction and surrounding each of the first semiconductor patterns, the third direction intersecting each of the first direction and the second direction; second word lines extending in the third direction and surrounding each of the second semiconductor patterns; a capacitor structure including first bottom electrodes contacting a first surface of the first semiconductor patterns, second bottom electrodes contacting a first surface of the second semiconductor patterns, and a dielectric layer covering the first bottom electrodes and the second bottom electrodes; and a support structure on the upper surface of the substrate and including a first supporter layer extending in the second direction, wherein the first supporter layer includes a first portion on a side surface of each of the first word lines and partially overlapping the first bottom electrodes in the third direction, and a second portion on a side surface of each of the second word lines and partially overlapping the second bottom electrodes in the third direction.

According to an embodiment, the first portion at least partially overlaps the first bottom electrodes in third direction and the second portion at least partially overlaps the second bottom electrodes in the third direction. The first bottom electrodes may be partially or completely overlapped in third direction by at least a part of the first portion. The second bottom electrodes may be partially or completely overlapped in third direction by at least a part of the second portion.

According to an aspect of the disclosure, a semiconductor device includes: a substrate; first semiconductor patterns extending in a first direction on an upper surface of the substrate, the first semiconductor patterns being stacked on and spaced apart from each other in a second direction intersecting the first direction; second semiconductor patterns spaced apart from the first semiconductor patterns in the first direction; a plurality of word lines extending in a third direction and surrounding each of the first semiconductor patterns and the second semiconductor patterns, the third direction intersecting each of the first direction and the second direction; a capacitor structure including first bottom electrodes contacting a first surface of the first semiconductor patterns, second bottom electrodes contacting a first surface of the second semiconductor patterns, and a dielectric layer covering the first bottom electrodes and the second bottom electrodes; a first bit line contacting a second surface of the first semiconductor patterns opposite the first surface of the first semiconductor patterns; a second bit line contacting a second surface opposite of the second semiconductor patterns the first surface of the second semiconductor patterns; and a support structure on the upper surface of the substrate, wherein the support structure includes a first supporter layer, and a second supporter layer spaced apart from the first supporter layer in the first direction and the third direction, wherein the first supporter layer partially overlaps the first bottom electrodes and the second bottom electrodes in the third direction, and the second supporter layer partially overlaps the second bit line in the third direction.

According to an aspect of the disclosure, a semiconductor device includes: a substrate; first semiconductor patterns extending in a first direction on an upper surface of the substrate, the first semiconductor patterns being stacked on and spaced apart from each other in a second direction intersecting the first direction; second semiconductor patterns spaced apart from the first semiconductor patterns in the first direction; a plurality of word lines including first word lines extending in a third direction intersecting each of the first direction and the second direction and surrounding each of the first semiconductor patterns, and second word lines surrounding each of the second semiconductor patterns; a capacitor structure including first bottom electrodes contacting a first surface of the first semiconductor patterns, second bottom electrodes contacting a first surface of the second semiconductor patterns, and a dielectric layer covering the first bottom electrodes and the second bottom electrodes; a first bit line contacting a second surface of the first semiconductor patterns opposite the first surface of the first semiconductor patterns; a second bit line contacting a second surface of the second semiconductor patterns opposite the first surface of the second semiconductor patterns; a first supporter layer on the upper surface of the substrate and partially overlapping the first bottom electrodes and the second bottom electrodes in the third direction; a second supporter layer on the upper surface of the substrate and partially overlapping the second bit line in the third direction; and a third supporter layer on the upper surface of the substrate and partially overlapping the first bit line in the third direction, wherein the first word lines are between the first supporter layer and the third supporter layer in the first direction, and the second word lines are between the first supporter layer and the second supporter layer in the first direction.

According to one or more embodiments of the present disclosure, the mechanical reliability of a semiconductor device may be improved.

At least some of the above and other features of the invention are set out in the claims.

### BRIEF DESCRIPTION OF THE DRAWINGS

FIG. 1 is a perspective view illustrating some components of a semiconductor device according to one or more embodiments of the present disclosure.
FIG. 2 is a plan view schematically illustrating a semiconductor device according to one or more embodiments of the present disclosure.
FIG. 3 is an enlarged view showing region Q of FIG. 2.
FIG. 4 is a cross-sectional view illustrating a cross-section taken along the line A-A' of FIG. 3.
FIG. 5 is a cross-sectional view illustrating a cross-section taken along the line B-B' of FIG. 3.
FIG. 6 is a plan view schematically illustrating a semiconductor device according to one or more embodiments of the present disclosure.
FIG. 7 is a cross-sectional view illustrating a cross-section taken along the line C-C' of FIG. 6.
FIG. 8 is a plan view schematically illustrating a semiconductor device according to one or more embodiments of the present disclosure.
FIG. 9 is a plan view schematically illustrating a semiconductor device according to one or more embodiments of the present disclosure.
FIG. 10 is a plan view schematically illustrating a semiconductor device according to one or more embodiments of the present disclosure.
FIGS. 11, 12, 13, 14, 15, 16, 17, and 18 are diagrams illustrating a method of manufacturing a semiconductor device according to one or more embodiments of the present disclosure.

### DETAILED DESCRIPTION

Hereinafter, one or more embodiments of the present disclosure will be described in detail with reference to the drawings.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

Terms such as first, second, etc. may be used to describe various components, but are used only for the purpose of distinguishing one component from another component. These terms do not limit the difference in the material or structure of the components.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

The terms "upper", "middle", "lower" may refer to relative positions along a particular direction (e.g. a second direction that is perpendicular to an upper surface of the substrate). Various directions (e.g. vertical direction, horizontal direction, etc.) may be defined relative to the structure of the devices described herein. For instance, first and third directions may be defined parallel to the upper surface of the substrate and the second direction may be defined perpendicular to the upper surface of the substrate. The second direction may be a vertical direction. Relative vertical positions (e.g., heights) may be defined based on relative positions along the second direction. It will be appreciated that the directions, positions and orientations described herein do not necessarily imply any particular orientation of the device in use.

The term "overlap" (or "overlapping", or like terms), as may be used herein, is intended to broadly refer to a first element that intersects with at least a portion of a second element when viewed in a particular direction, but does not require that the first and second elements be completely aligned with one another. Components or layers described with reference to "overlap" in a particular direction may be at least partially obstructed by one another when viewed along a line extending in the particular direction. For instance, components or layers described with reference to "overlap" in a particular direction may be positioned such that a line that runs parallel to the particular direction may be positioned such that it intersects at least a portion of each of the components or layers.

As used herein, the terms "substantially," "about," and similar terms are used as terms of approximation and not as terms of degree, and are intended to account for the inherent variations in measured or calculated values that would be recognized by those of ordinary skill in the art.

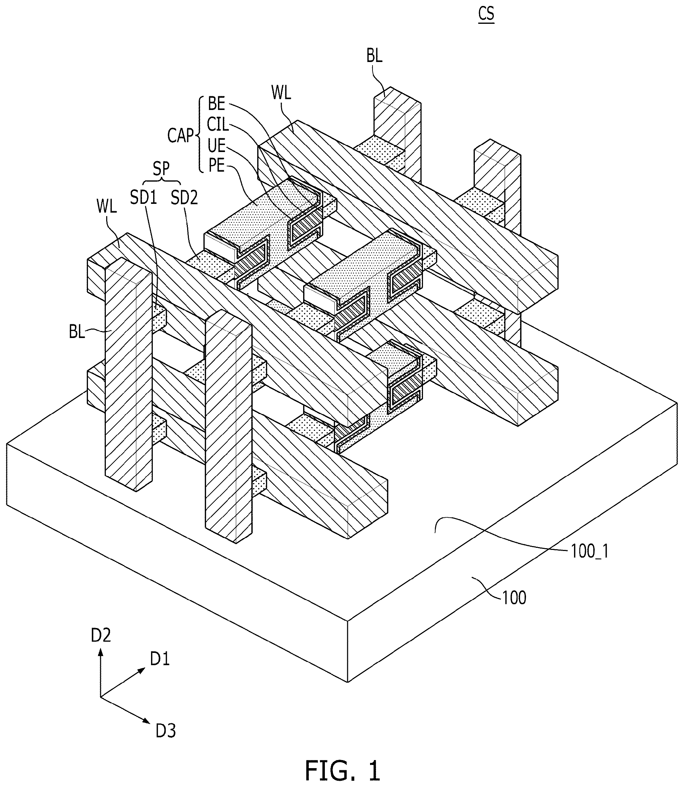

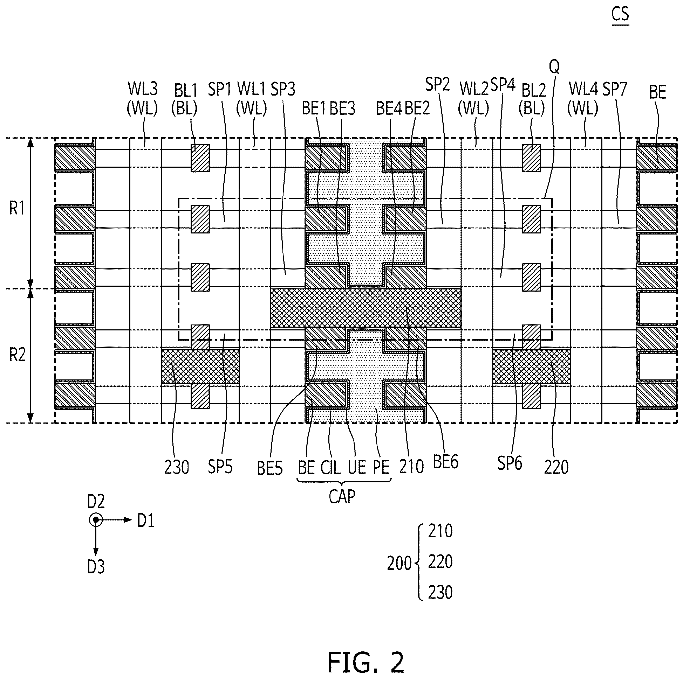

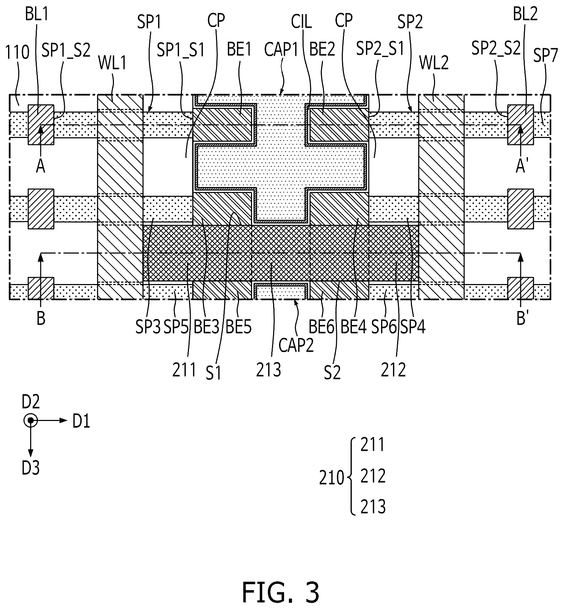

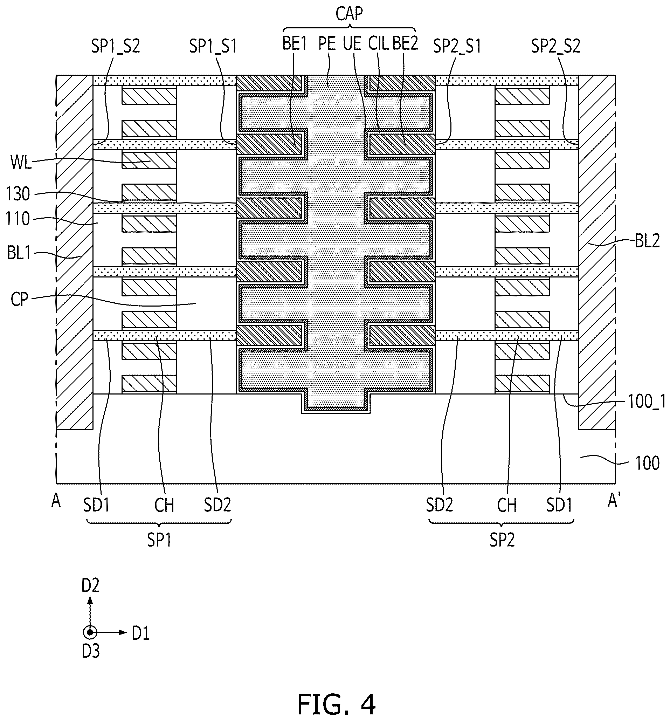

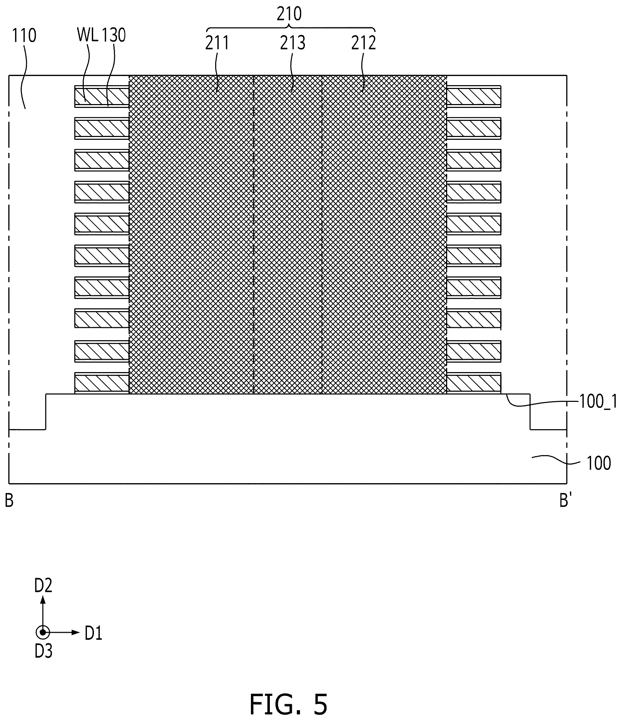

FIG. 1 is a perspective view illustrating some components of a semiconductor device according to one or more embodiments of the present disclosure. FIG. 2 is a plan view schematically illustrating a semiconductor device according to one or more embodiments of the present disclosure. FIG. 3 is an enlarged view showing region Q of FIG. 2. FIG. 4 is a cross-sectional view illustrating a cross-section taken along the line A-A' of FIG. 3. FIG. 5 is a cross-sectional view illustrating a cross-section taken along the line B-B' of FIG. 3.

Referring to FIG. 1, a semiconductor device according to one or more embodiments of the present disclosure may include a memory cell structure CS.

The memory cell structure CS may include at least one of various types of memory semiconductors (e.g., memory storage cells). For example, the memory cell structure CS may include a dynamic random access memory (DRAM) such as a three-dimensional (3D) memory such as a Vertically Stacked DRAM (VSDRAM).

A substrate 100 may be a semiconductor substrate. The substrate 100 may be bulk silicon or silicon-on-insulator (SOI). Alternatively, the substrate 100 may include silicon germanium (SiGe), silicon germanium on insulator (SGOI), indium antimonide, lead telluride compound, indium arsenide, indium phosphide, gallium arsenide, or gallium antimonide, but is not limited thereto.

A first surface 100_1 of the substrate 100 may be referred to as an upper surface. A direction perpendicular to the first surface 100_1 of the substrate 100 may be defined as a second direction D2, and directions parallel to the first surface 100_1 of the substrate 100 may be defined as a first direction D1 and a third direction D3. The third direction D3 may be a direction perpendicular to each of the first direction D1 and the second direction D2.

Each of a plurality of semiconductor patterns SP may be disposed on the first surface 100_1 of the substrate 100 to extend in the first direction D1. The plurality of semiconductor patterns SP may be stacked to be spaced apart in the second direction D2. In addition, the semiconductor patterns SP may be spaced apart from each other in the first direction D1 and the third direction D3. That is, the semiconductor patterns SP may be three-dimensionally arranged on the first surface 100_1 of the substrate 100. The semiconductor patterns SP may include a semiconductor material. For example, the semiconductor patterns SP may include at least one of silicon and germanium. As an example, the semiconductor patterns SP may include single-crystal silicon.

Each of the semiconductor patterns SP may have a bar shape with a long axis in the first direction D1. Each of the semiconductor patterns SP may include a first source/drain region SD1 and a second source/drain region SD2 spaced apart from each other, and a channel region CH between the first source/drain region SD1 and the second source/drain region SD2. The first source/drain region SD1 may be adjacent to a bit line BL, and the second source/drain region SD2 may be adjacent to a capacitor structure CAP. The first source/drain region SD1 and the second source/drain region SD2 may be doped with impurities.

The semiconductor patterns SP may respectively penetrate word lines WL in the first direction D1. A part of the semiconductor patterns SP may be surrounded by the word lines WL. Each of the word lines WL may have a structure surrounding a channel region CH of each of the semiconductor patterns SP (i.e., a gate-all-around structure). For instance, each of the wordlines WL may surround a channel region CH of each of the semiconductor patterns SP that are arranged in a corresponding row in the third direction D3. A gate insulating film 130 may be interposed between the channel region CH of each of the semiconductor patterns SP and the word lines WL.

Each of a plurality of word lines WL may extend along the third direction D3. Memory cells arranged along the third direction D3 may be commonly connected to one word line WL. The plurality of word lines WL may be arranged along the first direction D1 and/or the second direction D2. The plurality of word lines WL may be stacked on the first surface 100_1 of the substrate 100 to be spaced apart in the second direction D2. The plurality of word lines WL may include a conductive material. For example, the conductive material may be any one of a semiconductor material, a conductive metal nitride, a metal, or a metal-semiconductor compound.

Each of a plurality of bit lines BL may be disposed on the first surface 100_1 of the substrate 100 to extend in the second direction D2. The bit lines BL may have substantially the same length in the second direction D2. The bit lines BL may be arranged to be spaced apart from each other in the first direction D1 and the third direction D3. Each of the bit lines BL may be connected to the first source/drain region SD1 of each of the semiconductor patterns SP stacked (e.g., in a column) in the second direction D2.

The bit line BL may include a conductive material. The conductive material may be, for example, any one of a doped semiconductor material such as doped silicon or doped germanium, a conductive metal nitride such as titanium nitride or tantalum nitride, a metal such as tungsten, titanium, or tantalum, or a metal-semiconductor compound such as tungsten silicide, cobalt silicide, or titanium silicide.

Each of a plurality of capacitor structures CAP may include a bottom electrode BE, a dielectric layer CIL, a top electrode UE, and a plate electrode PE. Each of the plurality of capacitor structures CAP may be connected to the second source/drain region SD2 of each of the semiconductor patterns SP. For example, a plurality of bottom electrodes BE of the capacitor structure CAP may be respectively connected to the second source/drain region SD2 of each of the semiconductor patterns SP.

The bottom electrode BE may be disposed on one side surface of the semiconductor pattern SP. As an example, the bottom electrode BE may include at least one of a metal material such as titanium (Ti), tantalum (Ta), tungsten (W), copper (Cu), or aluminum (Al), a conductive metal nitride such as titanium nitride (TiN), tantalum nitride (TaN), and tungsten nitride (WN), or a doped semiconductor material such as doped silicon or doped germanium.

The bottom electrodes BE may be provided at substantially the same vertical level (e.g., as defined in the second direction D2) as the corresponding semiconductor patterns SP. A thickness of the bottom electrodes BE may be greater than or equal to a thickness of the semiconductor patterns SP. That is, the bottom electrodes BE may be stacked in the second direction D2 and may have a long axis (e.g., may extend) in the first direction D1. In one or more embodiments, an interface layer may be interposed between the bottom electrode BE and the semiconductor pattern SP. The interface layer may include, for example, a silicide film.

The dielectric layer CIL may conformally cover a surface of a bottom electrode BE. The dielectric layer CIL may be interposed between the bottom electrode BE and the top electrode UE. The dielectric layer CIL may include a high-k material. A high-k material may be a material having a dielectric constant that is higher than that of silicon oxide. For example, the dielectric layer CIL may include titanium oxide (TiO₂). In one or more embodiments, the dielectric layer CIL may include hafnium oxide, hafnium silicon oxide, lanthanum oxide, zirconium oxide, zirconium silicon oxide, tantalum oxide, barium strontium titanium oxide, barium titanium oxide, strontium titanium oxide, lithium oxide, aluminum oxide, lead scandium tantalum oxide, lead zinc niobate, or a combination thereof. In one or more embodiments, the dielectric layer CIL may be configured as a single film or a multi-film.

The top electrode UE may conformally cover a surface of the dielectric layer CIL. The top electrode UE may be disposed on the dielectric layer CIL. For example, the top electrode UE may include at least one of titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), zirconium (Zr), and combinations thereof.

The plate electrode PE may be disposed on the top electrode UE. The plate electrode PE may fill a space between the top electrodes UE. For example, the plate electrode PE may include impurity-doped silicon (Si) or impurity-doped silicon-germanium (SiGe). The plate electrode PE may have a plate shape, in that it may have a body that extends in the second direction D2 and the third direction D3. The bottom electrodes BE may protrude into corresponding cavities in the plate electrode PE.

Referring to FIGS. 2, 3, 4, and 5, a semiconductor device according to one or more embodiments of the present disclosure may include a plurality of semiconductor patterns SP, a plurality of word lines WL, a gate insulating film 130, a plurality of bit lines BL, a capacitor structure CAP, and a support structure 200.

The substrate 100 may include a first region R1 and a second region R2, which are distinguished from each other with respect to a reference plane corresponding to a first side surface S1 of a first support layer 210. The first region R1 and the second region R2 may be adjacent to each other in the third direction D3. The first region R1 may be referred to as a cell region, and the second region R2 may be referred to as a dummy region. For example, memory cells in the first region R1 may perform (e.g. may be configured to perform) a data storage function. In contrast, memory cells in the second region R2 are not configured to perform normal data storage operations during normal memory operation. In one or more embodiments, a first support layer 210 is present in the second region R2, thereby defining the second region R2 as the dummy region. Accordingly, the second region R2 is distinguished from the first region R1 by the presence of the first support layer 210. For example, word line contacts connected to the plurality of word lines WL may be provided in the second region R2. In one or more embodiments, the capacitor structure CAP may not be provided in the second region R2.

The plurality of semiconductor patterns SP may extend in the first direction D1. The plurality of semiconductor patterns SP may be stacked on an upper surface 100_1 of the substrate 100 to be spaced apart from each other in the second direction D2. The plurality of semiconductor patterns SP may include first to seventh semiconductor patterns SP1-SP7.

The first to seventh semiconductor patterns SP1-SP7 may have a structure in which a plurality of semiconductor patterns SP are stacked to be spaced apart in the second direction D2. For example, in each of the semiconductor patterns SP constituting the first semiconductor patterns SP1, a first surface SP1_S1 may be connected to the capacitor structure CAP, and a second surface SP1_S2 may be connected to the bit line BL.

Each of the semiconductor patterns SP constituting the first to seventh semiconductor patterns SP1-SP7 may be disposed at substantially the same level(s). For example, the semiconductor patterns constituting the first semiconductor patterns SP1 and the semiconductor patterns constituting the second semiconductor patterns SP2 may be provided at substantially corresponding heights.

The first semiconductor patterns SP1 and the second semiconductor patterns SP2 may be provided in the first region R1. The second semiconductor patterns SP2 may be spaced apart from the first semiconductor patterns SP1 in the first direction D1. The seventh semiconductor patterns SP7 may be provided in the first region R1 and may be spaced apart from the second semiconductor patterns SP2 in the first direction D1. The seventh semiconductor patterns SP7 may face the first semiconductor patterns SP1 in the first direction D1 with respect to the second semiconductor patterns SP2. The second semiconductor patterns SP2 may be located between the first semiconductor patterns SP1 and the seventh semiconductor patterns SP7.

The third semiconductor patterns SP3 and the fourth semiconductor patterns SP4 may be provided in the first region R1. The third semiconductor patterns SP3 may be spaced apart from the first semiconductor patterns SP1 in the third direction D3. The fourth semiconductor patterns SP4 may be spaced apart from the second semiconductor patterns SP2 in the third direction D3. The third semiconductor patterns SP3 and the fourth semiconductor patterns SP4 may be spaced apart from each other in the first direction D1.

The fifth semiconductor patterns SP5 and the sixth semiconductor patterns SP6 may be provided in the second region R2. The fifth semiconductor patterns SP5 may be spaced apart from the third semiconductor patterns SP3 in the third direction D3. The sixth semiconductor patterns SP6 may be spaced apart from the fourth semiconductor patterns SP4 in the third direction D3. The fifth semiconductor patterns SP5 and the sixth semiconductor patterns SP6 may be spaced apart from each other in the first direction D1.

In other words, the first semiconductor patterns SP1, the third semiconductor patterns SP3, and the fifth semiconductor patterns SP5 may be aligned in the third direction D3. In addition, the second semiconductor patterns SP2, the fourth semiconductor patterns SP4, and the sixth semiconductor patterns SP6 may be aligned in the third direction D3. In addition, some of the plurality of semiconductor patterns SP may be disposed in the first region R1, and others may be disposed in the second region R2.

The plurality of word lines WL may extend in the third direction D3. The plurality of word lines WL may be stacked to be spaced apart in the second direction D2. The plurality of word lines may comprise first word lines WL1 and second word lines WL2. The first word lines WL1 may be spaced apart from the second word lines WL2 in the first direction D1. The first word lines WL1 may be stacked to be spaced apart from each other in the second direction D2. The second word lines WL2 may be stacked to be spaced apart from each other in the second direction D2. One of the first word lines WL1 may be connected to one of the first semiconductor patterns SP1, one of the third semiconductor patterns SP3, and one of the fifth semiconductor patterns SP5. One of the second word lines WL2 may be connected to one of the second semiconductor patterns SP2, one of the fourth semiconductor patterns SP4, and one of the sixth semiconductor patterns SP6. For example, each of the first word lines WL1 may be connected to semiconductor patterns among the first semiconductor patterns SP1, the third semiconductor patterns SP3, and the fifth semiconductor patterns SP5 that are arranged at substantially the same vertical level along the third direction D3, and each of the second word lines WL2 may be connected to semiconductor patterns among the second semiconductor patterns SP2, the fourth semiconductor patterns SP4, and the sixth semiconductor patterns SP6 that are arranged at substantially the same vertical level along the third direction D3.

An interlayer insulating film 110 may be interposed between adjacent word lines WL among the plurality of word lines WL (e.g., in the second direction D2). As an example, the interlayer insulating film 110 may include at least one of a silicon nitride film, a silicon oxynitride film, a carbon-containing silicon oxide film, a carbon-containing silicon nitride film, and a carbon-containing silicon oxynitride film.

Although the interlayer insulating film 110 is shown as a single film, the interlayer insulating film 110 may also be composed of multiple films. The plurality of word lines WL and the plurality of interlayer insulating films 110 may be alternately stacked on each other. One end of the plurality of word lines WL and the plurality of interlayer insulating films 110 may have a step.

The gate insulating film 130 may be interposed between a word line WL and a semiconductor pattern SP. The gate insulating film 130 may surround a channel region CH of the semiconductor pattern SP. The channel region CH may be spaced apart from the word line WL by the gate insulating film 130. The gate insulating film 130 may not contact the first and second source/drain regions SD1, SD2 of the semiconductor pattern SP.

The gate insulating film 130 may include at least one of a high-k dielectric film, a silicon oxide film, a silicon nitride film, and a silicon oxynitride film. The high-k dielectric film may include, for example, at least one of hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

Capping patterns CP may be interposed between the word lines WL and the capacitor structure CAP. The capping patterns CP may be interposed between second source/drain regions SD2 of semiconductor patterns SP that are spaced apart from each other in the second direction D2. The capping patterns CP may surround the second source/drain regions SD2. A capping pattern CP may be interposed between second source/drain regions SD2 of semiconductor patterns SP that are spaced apart from each other in the second direction D2. The capping pattern CP may cover a side surface of the interlayer insulating film 110, a side surface of the word line WL, a side surface of the gate insulating film 130, and a part of the second source/drain region SD2.

The capping patterns CP may include an insulating material. For example, the capping patterns CP may include at least one of silicon oxide, silicon nitride, and a combination thereof. Although the capping patterns CP are shown as a single film, the capping patterns CP may be composed of multiple films.

Each of the plurality of bit lines BL may be connected to the plurality of semiconductor patterns SP (e.g., to a subset of the plurality of semiconductor patterns SP). Each of the plurality of bit lines BL may contact one side surface of each of the plurality of semiconductor patterns SP (e.g., one side surface of each of a subset of the plurality of semiconductor patterns SP). For example, a first bit line BL1 may contact a second surface SP1_S2 of each of the first semiconductor patterns SP1, and a second bit line BL2 may contact a second side surface SP2_S2 of each of the second semiconductor patterns SP2.

Each of the plurality of bit lines BL may be connected to each of the first to seventh semiconductor patterns SP1-SP7. Each of the plurality of bit lines BL may be connected to each of one or more of the first to seventh semiconductor patterns SP1-SP7. Each of the plurality of bit lines BL may be connected to an adjacent pair of the first to seventh semiconductor patterns SP1-SP7. For example, the second bit line BL2 may be connected to each of the second semiconductor patterns SP2 and the seventh semiconductor patterns SP7. That is, the second semiconductor patterns SP2 may contact one surface of the second bit line BL2, and the seventh semiconductor patterns SP7 may contact the other surface of the second bit line BL2.

The capacitor structure CAP may include first to sixth bottom electrodes BE1-BE6, the dielectric layer CIL, the top electrode UE, and the plate electrode PE.

Each of the first to sixth bottom electrodes BE1-BE6 may be provided on the first to sixth semiconductor patterns SP1-SP6. For example, each of the first to sixth bottom electrodes BE1-BE6 may contact one side surface of the first to sixth semiconductor patterns SP1-SP6. That is, the bit line BL may contact one side surface of the first to sixth semiconductor patterns SP1-SP6, and the first to sixth bottom electrodes BE1-BE6 may respectively contact the other side surface of the first to sixth semiconductor patterns SP1-SP6. For instance, each of the first to sixth bottom electrodes BE1-BE6 may be connected to a corresponding one of the first to sixth semiconductor patterns SP1-SP6.

The first bottom electrodes BE1 and the second bottom electrodes BE2 may be provided in the first region R1. The second bottom electrodes BE2 may be spaced apart from the first bottom electrodes BE1 in the first direction D1. The first bottom electrodes BE1 may be stacked to be spaced apart from each other in the second direction D2. The second bottom electrodes BE2 may be stacked to be spaced apart from each other in the second direction D2.

The third bottom electrodes BE3 may be spaced apart from the first bottom electrodes BE1 in the third direction D3. The fourth bottom electrodes BE4 may be spaced apart from the second bottom electrodes BE2 in the third direction D3. The third bottom electrodes BE3 and the fourth bottom electrodes BE4 may be spaced apart from each other in the first direction D1. The third bottom electrodes BE3 may be stacked to be spaced apart from each other in the second direction D2. The fourth bottom electrodes BE4 may be stacked to be spaced apart from each other in the second direction D2.

The fifth bottom electrodes BE5 may be spaced apart from the third bottom electrodes BE3 in the third direction D3. The sixth bottom electrodes BE6 may be spaced apart from the fourth bottom electrodes BE4 in the third direction D3. The fifth bottom electrodes BE5 and the sixth bottom electrodes BE6 may be spaced apart from each other in the first direction D1. The fifth bottom electrodes BE5 may be stacked to be spaced apart from each other in the second direction D2. The sixth bottom electrodes BE6 may be stacked to be spaced apart from each other in the second direction D2.

The first bottom electrodes BE1, the third bottom electrodes BE3, and the fifth bottom electrodes BE5 may be aligned in the third direction D3. In addition, the second bottom electrodes BE2, the fourth bottom electrodes BE4, and the sixth bottom electrodes BE6 may be aligned in the third direction D3.

The dielectric layer CIL and the top electrode UE may be sequentially disposed on the bottom electrodes BE. The dielectric layer CIL and the top electrode UE may be conformally formed on the bottom electrodes BE and the capping patterns CP. The dielectric layer CIL may be disposed on the first to sixth bottom electrodes BE1-BE6 and the capping patterns CP. The top electrode UE may be disposed on the dielectric layer CIL. The plate electrode PE may fill the space between the top electrodes UE.

For example, referring to FIG. 4, the first bottom electrodes BE1 may be provided on a first surface SP1_S1 of the first semiconductor patterns SP1, and a first bit line BL1 may be provided on a second surface SP1_S2 of the first semiconductor patterns SP1. The first surface SP1_S1 of the first semiconductor patterns SP1 may be opposite to the second surface SP1_S2 of the first semiconductor patterns SP1 in the first direction D1. The second bottom electrodes BE2 may be provided on a first surface SP2_S1 of the second semiconductor patterns SP2, and a second bit line BL2 may be provided on a second surface SP2_S2 of the second semiconductor patterns SP2. The first surface SP2_S1 of the second semiconductor patterns SP2 may be opposite to the second surface SP2_S2 of the second semiconductor patterns SP2 in the first direction D1.

The first bottom electrodes BE1 and the second bottom electrodes BE2 may be disposed to face each other. The first bottom electrodes BE1 and the second bottom electrodes BE2 may be spaced apart from each other in the first direction D1.

The dielectric layer CIL may cover the capping patterns CP, the first bottom electrodes BE1, and the second bottom electrodes BE2. The dielectric layer CIL may be disposed on the capping patterns CP.

Referring again to FIGS. 2-5, the support structure 200 may include a first supporter layer 210, a second supporter layer 220, and a third supporter layer 230. The support structure 200 may be disposed on the upper surface 100_1 of the substrate 100. The support structure 200 may be disposed in the second region R2. The support structure 200 may include not only the three supporter layers illustrated in FIGS. 2-5 but also four or more supporter layers, and is not limited thereto. That is, the support structure 200 may include any number of (e.g., one or more) supporter layers.

The support structure 200 may include a material having an etch selectivity with respect to silicon oxide. For example, the support structure 200 may include silicon nitride (SiN). However, embodiments of the present disclosure are not limited thereto, and the support structure 200 may include other materials.

The first supporter layer 210 may extend in the first direction D1 from a planar perspective (e.g., in a plane defined by the first direction D1 and the third direction D3). In addition, the first supporter layer 210 may have a vertical cross-section extending in the second direction D2 from the upper surface 100_1 of the substrate 100.

The first supporter layer 210 may include a first portion 211, a second portion 212, and a connection portion 213.

The first portion 211 may at least partially overlap the first bottom electrodes BE1 in the third direction D3. For instance, at least part of the first portion 211 may overlap the first bottom electrodes BE1 in the third direction D3. The first portion 211 may overlap a part of the first semiconductor patterns SP1 in the third direction D3. For example, the first portion 211 may overlap the second source/drain region SD2 of the first semiconductor patterns SP1 and the first bottom electrodes BE1 in the third direction D3.

The first portion 211 may be disposed between the third semiconductor patterns SP3 and the third bottom electrodes BE3, and the fifth semiconductor patterns SP5 and the fifth bottom electrodes BE5 (e.g., in the third direction D3). The third bottom electrodes BE3 may contact one side surface of the first portion 211, and the fifth bottom electrodes BE5 may contact the other side surface of the first portion 211 (e.g., in the third direction D3).

The second portion 212 may at least partially overlap the second bottom electrodes BE2 in the third direction D3. For instance, at least part of the second portion 212 may overlap the second bottom electrodes BE2 in the third direction D3. The second portion 212 may overlap a part of the second semiconductor patterns SP2 in the third direction D3. For example, the second portion 212 may overlap the second source/drain region SD2 of the second semiconductor patterns SP2 and the second bottom electrodes BE2 in the third direction D3.

The second portion 212 may be disposed between the fourth semiconductor patterns SP4 and the fourth bottom electrodes BE4, and the sixth semiconductor patterns SP6 and the sixth bottom electrodes BE6 (e.g., in the third direction D3). The fourth bottom electrodes BE4 may contact one side surface of the second portion 212, and the sixth bottom electrodes BE6 may contact the other side surface of the second portion 212 (e.g., in the third direction D3).

The connection portion 213 may be disposed between the first portion 211 and the second portion 212. The connection portion 213 may connect the first portion 211 and the second portion 212. The connection portion 213 may not overlap with the first bottom electrodes BE1 and the second bottom electrodes BE2 in the third direction D3.

The first supporter layer 210 may be disposed between the first word lines WL1 and the second word lines WL2 in the first direction D1. The first supporter layer 210 may extend between a side surface of each of the first word lines WL1 and a side surface of each of the second word lines WL2 in the first direction D1. The first supporter layer 210 may contact one side surface of each of the first word lines WL1 and one side surface of each of the second word lines WL2. In this case, the one side surface of each of the first word lines WL1 and the one side surface of each of the second word lines WL2 may be surfaces facing each other. The first supporter layer 210 may extend in the first direction D1 between the one side surface of each of the first word lines WL1 and the one side surface of each of the second word lines WL2.

In some other embodiments, unlike as illustrated in FIGS. 2, 3, and 5, the first supporter layer 210 may be spaced apart from one or more of the word lines WL. For example, the first supporter layer 210 may be spaced apart from the first word lines WL1 in the first direction D1 with a first insulating film interposed therebetween, and/or may be spaced apart from the second word lines WL2 in the first direction D1 with a second insulating film interposed therebetween. In one or more embodiments, the first insulating film and the second insulating film may include a material different from the first supporter layer 210, for example, silicon oxide, but are not limited thereto. In one or more embodiments, the first portion 211 and the second portion 212 of the first supporter layer 210 may overlap with a part of one or more (e.g., each) of the semiconductor patterns SP in the third direction D3. In some other embodiments, the first portion 211 and the second portion 212 of the first supporter layer 210 may overlap with the bottom electrodes BE in the third direction D3, but may not overlap with the semiconductor patterns SP in the third direction D3. For example, the first portion 211 and the second portion 212 may be disposed between two adjacent bottom electrodes BE in the third direction D3 in the dummy region R2, but may not be disposed between two adjacent semiconductor patterns SP in the third direction D3.

The first supporter layer 210 may partition the capacitor structure CAP into a first capacitor structure CAP1 and a second capacitor structure CAP2. That is, the first supporter layer 210 may be disposed between the first capacitor structure CAP1 and a second capacitor structure CAP2. A first side surface S1 of the first supporter layer 210 may contact each of the third bottom electrodes BE3 and the fourth bottom electrodes BE4 (e.g., in the third direction D3), and a second side surface S2 of the first supporter layer 210 may contact each of the fifth bottom electrodes BE5 and the sixth bottom electrodes BE6 (e.g., in the third direction D3). The first side surface S1 may be opposite to the second side surface S2 in the third direction D3.

A part of the dielectric layer CIL may extend in the first direction D1 on the first supporter layer 210. For example, a part of the dielectric layer CIL may extend in the first direction D1 on the connection portion 213. A part of the dielectric layer CIL may extend along the first side surface S1 of the first supporter layer 210 between the third bottom electrodes BE3 and the fourth bottom electrodes BE4. Another part of the dielectric layer CIL may extend along the second side surface S2 of the first supporter layer 210 between the fifth bottom electrodes BE5 and the sixth bottom electrodes BE6.

A part of the top electrode UE and a part of the plate electrode PE may overlap with the connection portion 213 in the third direction D3. A part of the dielectric layer CIL, a part of the top electrode UE, and a part of the plate electrode PE may be sequentially disposed on the connection portion 213. A part of the dielectric layer CIL and a part of the top electrode UE may extend along the surfaces of the third bottom electrode BE3, the connection portion 213, and the fourth bottom electrode BE4.

The second supporter layer 220 may be spaced apart from the first supporter layer 210 in the first direction D1 and the third direction D3. Here, that the second supporter layer 220 is spaced apart from the first supporter layer 210 in the first direction D1 may indicate that the centers of each of the second supporter layer 220 and the first supporter layer 210 in the first direction D1 are spaced apart from each other (i.e., offset) in the first direction D1. Accordingly, the first supporter layer 210 and the second supporter layer 220 need not be aligned in the first direction D1 (e.g., may be offset in the second direction D2).

The second supporter layer 220 may at least partially overlap the second bit line BL2 in the third direction D3. For instance, a portion of the second supporter layer 220 may overlap the second bit line BL2 in the third direction D3. The second supporter layer 220 may be disposed between a second word line WL2 and a fourth word line WL4. The fourth word line WL4 may extend in the third direction D3 and may be spaced apart from the second word line WL2 in the first direction D3. A plurality of fourth word lines WL4 may be stacked to be spaced apart from each other in the second direction D2. The second supporter layer 220 may contact one side surface of each of the second word lines WL2 and one side surface of each of the fourth word lines WL4. The one side surface of each of the second word lines WL2 and the one side surface of each of the fourth word lines WL4 may be surfaces facing each other. The second supporter layer 220 may extend in the first direction D1 between the one side surface of each of the second word lines WL2 and the one side surface of each of the fourth word lines WL4. In one or more embodiments, the second supporter layer 220 may be composed of two parts spaced apart from each other in the first direction D1. In this case, the second supporter layer 220 may not overlap with the second bit line BL2 (e.g., in the second direction D3).

The second word lines WL2 may be located between the first supporter layer 210 and the second supporter layer 220 in the first direction D1. The first supporter layer 210 may contact one side surface of the second word lines WL2, and the second supporter layer 220 may contact the other side surface of the second word line WL2.

The third supporter layer 230 may be spaced apart from the first supporter layer 210 in the first direction D1 and the third direction D3. The third supporter layer 230 may be spaced apart from the second supporter layer 220 in the first direction D1. The second supporter layer 220 and the third supporter layer 230 may be aligned in the first direction D1. As an example, a distance between the first supporter layer 210 and the second supporter layer 220 and a distance between the first supporter layer 210 and the third supporter layer 230 may be substantially the same.

The third supporter layer 230 may at least partially overlap the first bit line BL1 in the third direction D3. For instance, a portion of the third supporter layer 230 may overlap the first bit line BL1 in the third direction D3. The third supporter layer 230 may be disposed between a first word line WL1 and a third word line WL3. The third word line WL3 may extend in the third direction D3 and may be spaced apart from the first word line WL1 in the first direction D3. A plurality of third word lines WL3 may be stacked to be spaced apart from each other in the second direction D2. The third supporter layer 230 may contact one side surface of each of the first word lines WL1 and one side surface of each of the third word lines WL3. The one side surface of each of the first word lines WL1 and the one side surface of each of the third word lines WL3 may be surfaces facing each other. The third supporter layer 230 may extend in the first direction D1 between the one side surface of each of the first word lines WL1 and the one side surface of each of the third word lines WL3. In one or more embodiments, the third supporter layer 230 may be composed of two parts spaced apart from each other in the first direction D1. In this case, the third supporter layer 230 may not overlap with the first bit line BL1 (e.g., in the second direction D3).

The first word lines WL1 may be disposed between the first supporter layer 210 and the third supporter layer 230 in the first direction D1. The first supporter layer 210 may contact one side surface of the first word lines WL1, and the third supporter layer 230 may contact the other side surface of the first word line WL1.

In some other embodiments, unlike as illustrated in FIG. 2, the second supporter layer 220 and the third supporter layer 230 may be spaced apart from the surrounding word lines WL, respectively. For example, the second supporter layer 220 may be spaced apart from the second word lines WL2 and the third word lines WL3 in the first direction D1 with an insulating film interposed therebetween. For example, the third supporter layer 230 may be spaced apart from the first word lines WL1 and the second word lines WL2 in the first direction D1 with an insulating film interposed therebetween.

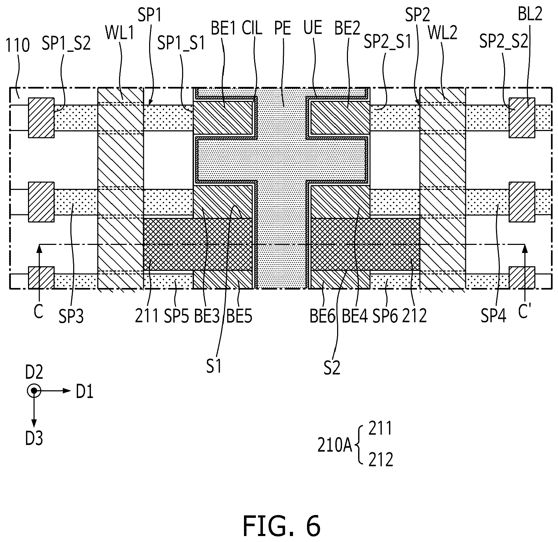

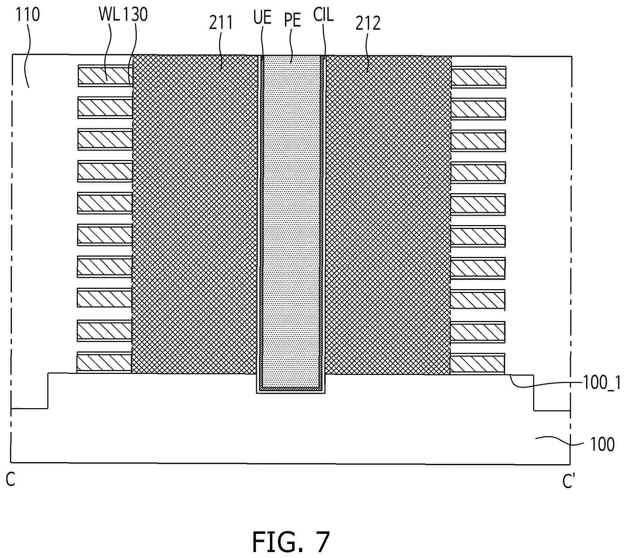

FIG. 6 is a plan view schematically illustrating a semiconductor device according to one or more embodiments of the present disclosure. FIG. 7 is a cross-sectional view illustrating a cross-section taken along the line C-C' of FIG. 6. The embodiments of FIGS. 6 and 7 will be described focusing on the differences from the embodiments of FIGS. 2-5.

Referring to FIGS. 6 and 7, a semiconductor device according to one or more embodiments of the present disclosure may include a first supporter layer 210A. The first supporter layer 210A may have a different shape from the first supporter layer 210 of FIG. 3.

The first supporter layer 210A may include a first portion 211 and a second portion 212. In the first supporter layer 210A, the first portion 211 and the second portion 212 may not be connected to each other (e.g., may be separated from each other). That is, the first supporter layer 210A may not include a connection portion.

A part of the capacitor structure CAP may be disposed between the first portion 211 and the second portion 212. That is, a part of the capacitor structure CAP may be located between the first portion 211 and the second portion 212 of the first supporter layer 210A. For example, the dielectric layer CIL, the top electrode UE, and the plate electrode PE may be disposed between the first portion 211 and the second portion 212 of the first supporter layer 210A. A part of the dielectric layer CIL may extend in the third direction D3 on the first portion 211 and the second portion 212. The dielectric layer CIL and the top electrode UE may be sequentially disposed on the first portion 211 and the second portion 212.

The third bottom electrodes BE3 and the fourth bottom electrodes BE4 may be disposed on a first side surface S1 of the first supporter layer 210A. The fifth bottom electrodes BE5 and the sixth bottom electrodes BE6 may be disposed on a second side surface S2 of the first supporter layer 210A.

The third bottom electrodes BE3 and the fifth bottom electrodes BE5 may be located on both sides of the first portion 211. The first portion 211 may be located between the third bottom electrodes BE3 and the fifth bottom electrodes BE5 in the third direction D3. The fourth bottom electrodes BE4 and the sixth bottom electrodes BE6 may be located on both sides of the second portion 212. In other words, the second portion 212 may be located between the fourth bottom electrodes BE4 and the sixth bottom electrodes BE6 in the third direction D3.

The third bottom electrodes BE3, the first portion 211, and the fifth bottom electrodes BE5 may be arranged side by side in the third direction D3. A part of the dielectric layer CIL may extend in the third direction D3 on the third bottom electrodes BE3, the first portion 211, and the fifth bottom electrodes BE5.

The fourth bottom electrodes BE4, the second portion 212, and the sixth bottom electrodes BE6 may be arranged side by side in the third direction D3. A part of the dielectric layer CIL may extend in the third direction D3 on the fourth bottom electrodes BE4, the second portion 212, and the sixth bottom electrodes BE6.

In some other embodiments, unlike as illustrated in FIGS. 6 and 7, the first supporter layer 210A may be spaced apart from the word lines WL. For example, the first portion 211 of the first supporter layer 210A may be spaced apart from the first word lines WL1 in the first direction D1 with a first insulating film interposed therebetween, and the second portion 212 of the first supporter layer 210A may be spaced apart from the second word lines WL2 in the first direction D1 with a second insulating film interposed therebetween.

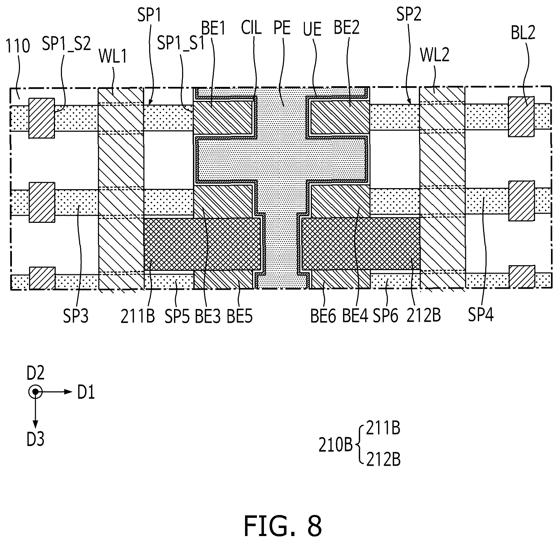

FIG. 8 is a plan view schematically illustrating a semiconductor device according to one or more embodiments of the present disclosure. The embodiment of FIG. 8 will be described focusing on the differences from the embodiment of FIG. 6.

Referring to FIG. 8, a semiconductor device according to one or more embodiments of the present disclosure may include a first supporter layer 210B. The first supporter layer 210B may have a different shape from the first supporter layer 210A of FIG. 6.

The first supporter layer 210B may include a first portion 211B and a second portion 212B. In the first supporter layer 210B, the first portion 211B and the second portion 212B may not be connected to each other (e.g., may be separated from each other). That is, the first supporter layer 210B may not include a connection portion.

A part of the capacitor structure CAP may be disposed between the first portion 211B and the second portion 212B. That is, a part of the capacitor structure CAP may be located between the first portion 211B and the second portion 212B. A part of the dielectric layer CIL may extend in the third direction D3 on the first portion 211B and the second portion 212B. The dielectric layer CIL and the top electrode UE may be sequentially disposed on the first portion 211B and the second portion 212B.

One end of each of the first portion 211B and the second portion 212B may protrude toward the capacitor structure CAP. One end of each of the first portion 211B and the second portion 212B may protrude toward the plate electrode PE. A part of the first portion 211B may protrude in the first direction D1 from (e.g., beyond) the third bottom electrodes BE3 and the fifth bottom electrodes BE5. A part of the second portion 212B may protrude in the first direction D1 from (e.g., beyond) the fourth bottom electrodes BE4 and the sixth bottom electrodes BE6. The part of the first portion 211B and the part of the second portion 212B may protrude toward each other. A distance in the first direction D1 between the first portion 211B and the second portion 212B may be smaller than a distance in the first direction D1 between the third bottom electrodes BE3 and the fourth bottom electrodes BE4. Similarly, a distance in the first direction D1 between the first portion 211B and the second portion 212B may be smaller than a distance in the first direction D1 between the fifth bottom electrodes BE5 and the sixth bottom electrodes BE6.

One end of the first portion 211B may have a step with a side surface of the third bottom electrodes BE3 and a side surface of the fifth bottom electrodes BE5. Due to this, the dielectric layer CIL may have a bent section while extending along the surfaces of the third bottom electrodes BE3 and the first portion 211B. In addition, the dielectric layer CIL may have a bent section while extending along the surfaces of the first portion 211B and the fifth bottom electrodes BE5. Specifically, a part of the dielectric layer CIL may include a portion extending in the first direction D1 on the first portion 211B.

One end of the second portion 212B may have a step with a side surface of the fourth bottom electrodes BE4 and a side surface of the sixth bottom electrodes BE6. Due to this, the dielectric layer CIL may have a bent section while extending along the surfaces of the fourth bottom electrodes BE4 and the second portion 212B. In addition, the dielectric layer CIL may have a bent section while extending along the surfaces of the second portion 212B and the sixth bottom electrodes BE6. Specifically, a part of the dielectric layer CIL may include a portion extending in the first direction D1 on the second portion 212B.

In one or more embodiments, one end of the first portion 211B may have a recessed shape from the side surface of the third bottom electrodes BE3 and the side surface of the fifth bottom electrodes BE5. One end of each of the second portions 212B may have a recessed shape from the side surface of the fourth bottom electrodes BE4 and the side surface of the sixth bottom electrodes BE6. In other words, a part of the capacitor structure CAP may protrude toward the first portion 211B and the second portion 212B.

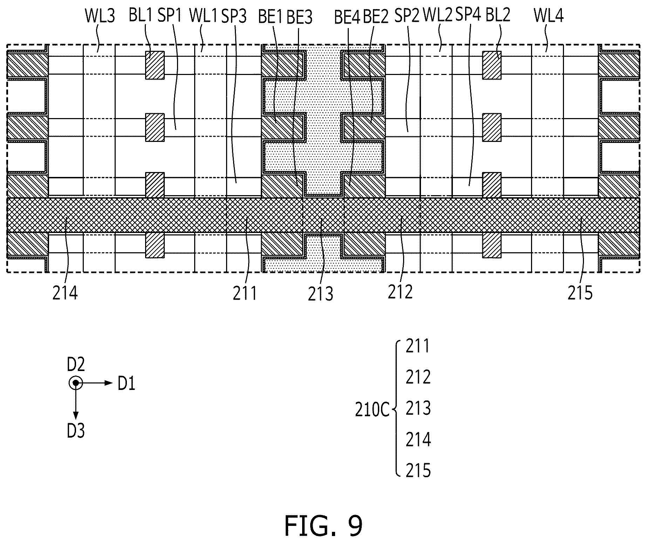

FIG. 9 is a plan view schematically illustrating a semiconductor device according to one or more embodiments of the present disclosure. The embodiment of FIG. 9 will be described focusing on the differences from the embodiments of FIGS. 2-5.

Referring to FIG. 9, a semiconductor device according to one or more embodiments of the present disclosure may include a first supporter layer 210C. The first supporter layer 210C may have a different shape from the first supporter layer 210 of FIG. 3.

The first supporter layer 210C may include a first portion 211, a second portion 212, a connection portion 213, a first extension portion 214, and a second extension portion 215. That is, the first supporter layer 210C may further include the first extension portion 214 and the second extension portion 215 compared to the first supporter layer 210 of FIG. 3.

The first extension portion 214 may extend in the first direction D1. The first extension portion 214 may extend from the first portion 211 in a direction away from the second portion 212. The first extension portion 214 may separate a first word line WL1 and a third word line WL3, respectively. The first word line WL1 and the third word line WL3 may each be spaced apart (e.g., in the first direction D1) with the first extension portion 214 interposed therebetween.

The second extension portion 215 may extend in the first direction D1. The second extension portion 215 may extend from the second portion 212 in a direction away from the first portion 211. The second extension portion 215 may separate a second word line WL2 and a fourth word line WL4, respectively. The second word line WL2 and the fourth word line WL4 may each be spaced apart (e.g., in the first direction D1) with the second extension portion 215 interposed therebetween. In one or more embodiments, a length of the first supporter layer 210C in the first direction D1 may be variously changed. In one or more embodiments, the first supporter layer 210C may extend from one side surface to the other side surface of a memory cell block.

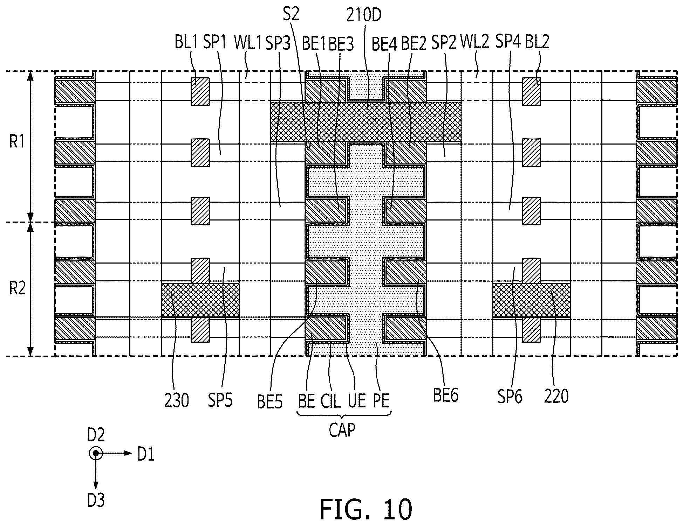

FIG. 10 is a plan view schematically illustrating a semiconductor device according to one or more embodiments of the present disclosure. The embodiment of FIG. 10 will be described focusing on the differences from the embodiments of FIGS. 2-5.

Referring to FIG. 10, a semiconductor device according to one or more embodiments of the present disclosure may include a first supporter layer 210D. The description of the first supporter layer 210D may be substantially the same as the description of the first supporter layer 210 of FIG. 3. However, the first supporter layer 210D may be disposed at a different location from the first supporter layer 210 of FIG. 3.

The first supporter layer 210D may be disposed in the first region R1. The first supporter layer 210D may be disposed in a cell region. That is, the first supporter layer 210D may be provided between memory cells that perform a data storage function. In one or more embodiments, the second supporter layer 220 and the third supporter layer 230 may be disposed in the first region R1.

The first supporter layer 210D may contact the first bottom electrodes BE1 and the second bottom electrodes BE2. For example, a second side surface S2 of the first supporter layer 210D may contact the first bottom electrodes BE1 and the second bottom electrodes BE2. The first supporter layer 210D may be spaced apart from the fifth bottom electrodes BE5 and the sixth bottom electrodes BE6 in the third direction D3.

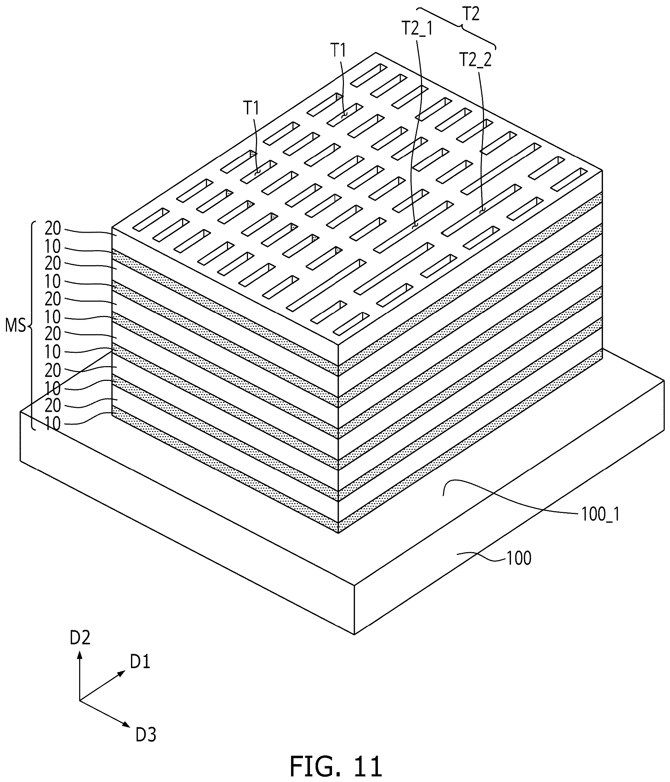

FIGS. 11-18 are diagrams illustrating a method of manufacturing a semiconductor device according to one or more embodiments of the present disclosure.

Referring to FIG. 11, a mold structure MS may be formed on an upper surface 100_1 of a substrate 100.

The mold structure MS may be formed by alternately stacking sacrificial films 10 and semiconductor films 20. The sacrificial films 10 may be formed of a material having an etch selectivity with respect to the semiconductor films 20. For example, the sacrificial films 10 may be formed of at least one of silicon germanium, silicon oxide, silicon nitride, and silicon oxynitride. When forming the mold structure MS, a thickness of each of the sacrificial films 10 may be smaller than a thickness of each of the semiconductor films 20.

The semiconductor films 20 may be formed of, for example, silicon, germanium, silicon-germanium, or Indium Gallium Zinc Oxide (IGZO). In one or more embodiments, the semiconductor films 20 may be formed of the same semiconductor material as the semiconductor substrate 100. For example, the semiconductor films 20 may be single-crystal silicon films or polycrystalline silicon films. In one or more embodiments, the sacrificial films 10 and the semiconductor films 20 may be formed by an epitaxial growth process. The semiconductor films 20 may be single-crystal silicon films, and the sacrificial films 10 may be silicon germanium films having a super lattice structure.

Subsequently, a plurality of first trenches T1 and a plurality of second trenches T2 penetrating the mold structure MS in the second direction D2 may be formed. Each of the plurality of first trenches T1 and the plurality of second trenches T2 may extend in the second direction D2. The plurality of first trenches T1 may be arranged to be spaced apart in the first direction D1 and the third direction D3.

The plurality of second trenches T2 may include a first plurality of second trenches T2_1 and a second plurality of second trenches T2_2. Each of the first plurality of second trenches T2_1 may be arranged to be spaced apart in the first direction D1. Each of the second plurality of second trenches T2_2 may be arranged to be spaced apart in the first direction D1. The first plurality of second trenches T2_1 and the second plurality of second trenches T2_2 may be spaced apart from each other in the third direction D3. The second plurality of second trenches T2_2 may be offset from the first plurality of second trenches T2_1 in the first direction D1. That is, the first plurality of second trenches T2_1 and the second plurality of second trenches T2_2 may be arranged in a staggered manner. For example, the plurality of second trenches T2 may be formed on a dummy region R2 (see FIG. 2), but is not limited thereto.

To form the plurality of first trenches T1 and the plurality of second trenches T2, a mask pattern having openings corresponding to the plurality of first trenches T1 and the plurality of second trenches T2 may be formed on the mold structure MS, and the mold structure MS may be anisotropically etched using the mask pattern as an etch mask. The plurality of first trenches T1 and the plurality of second trenches T2 may expose an upper surface of the substrate 100 and side surfaces of the semiconductor films 20.

Each of the plurality of first trenches T1 and the plurality of second trenches T2 may have a long axis (e.g., a length) in the first direction D1 and a short axis (e.g., a width, wherein the width is shorter than the length) in the third direction D3. A length of the long axis of the second trench T2 may be longer than a length of the long axis of the first trench T1. For example, the length of the long axis of the second trench T2 may be greater than twice the length of the long axis of the first trench T1. The second trench T2 may be formed by merging two adjacent first trenches T1 in the first direction D1. However, the second trench T2 may also be formed by merging three or more adjacent first trenches T1 in the first direction D1, and is not limited thereto.

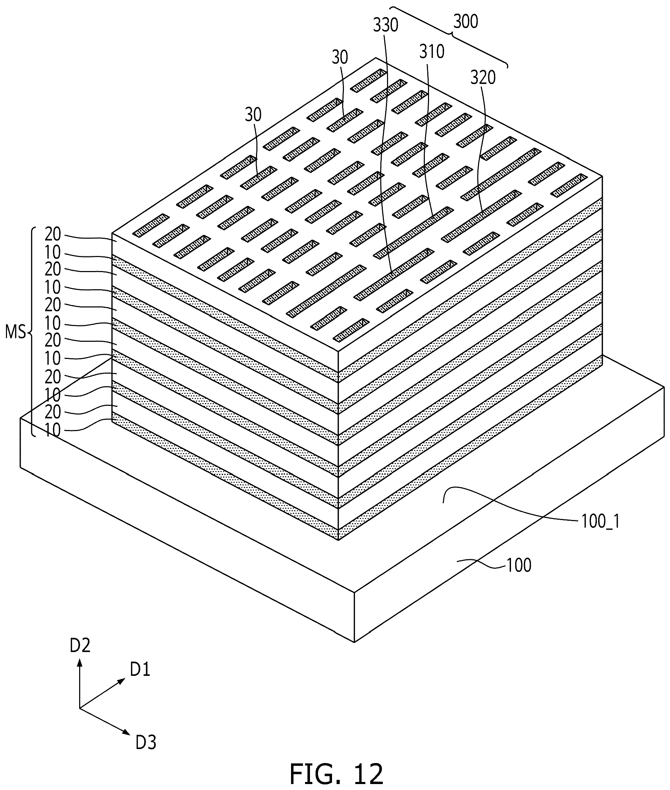

Referring to FIG. 12, first insulating layers 30 may be formed inside the first trenches T1, and preliminary supporter layers 300 may be formed inside the second trenches T2. The first insulating layers 30 and the preliminary supporter layers 300 may include at least one of silicon nitride, silicon oxynitride, etc. For example, the first insulating layers 30 and the preliminary supporter layers 300 may be formed by depositing an insulating material to fill the first trenches T1 and the second trenches T2, and planarizing until an upper surface of the mold structure MS is exposed.

The first insulating layers 30 and the preliminary supporter layers 300 may each penetrate the mold structure MS in the second direction D2. The first insulating layers 30 and the preliminary supporter layers 300 may extend in the second direction D2. The first insulating layers 30 and the preliminary supporter layers 300 may each be disposed on the upper surface 100_1 of the substrate 100 to be spaced apart from each other in the first direction D1 and the third direction D3.

The preliminary supporter layers 300 may include a first preliminary supporter layer 310, a second preliminary supporter layer 320, and a third preliminary supporter layer 330. A first part of the first preliminary supporter layer 310 may overlap with the second preliminary supporter layer 320 and a second part of the first preliminary supporter layer 310 may overlap with the third preliminary supporter layer 330 in the third direction D3.

A length of a long axis of each of the preliminary supporter layers 300 may be longer than a length of a long axis of each of the first insulating layers 30. For example, the length of the long axis of each of the preliminary supporter layers 300 may be greater than twice the length of the long axis of each of the first insulating layers 30.

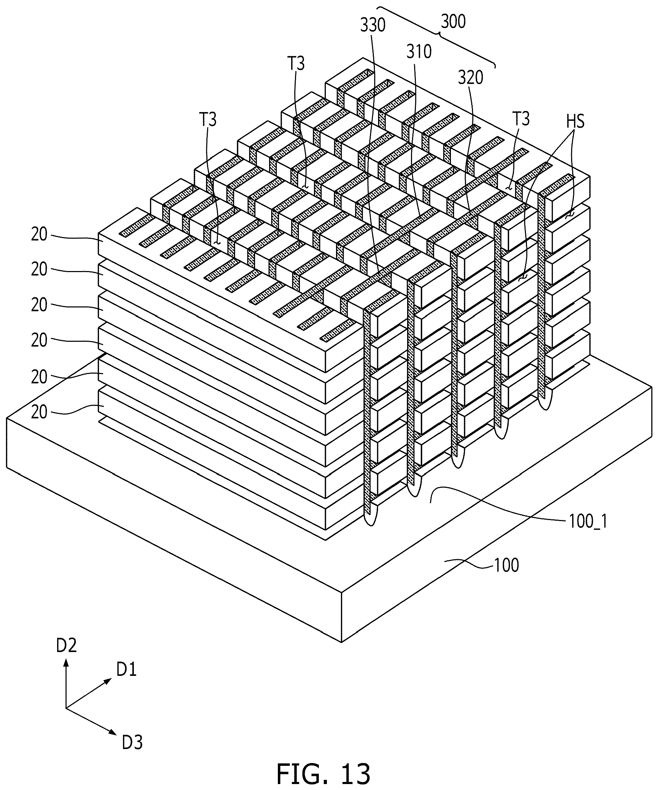

Referring to FIG. 13, a third trench T3 penetrating the mold structure MS in the second direction D2 may be formed. The third trench T3 may be formed between adjacent first insulating layers 30 in the first direction D1. The third trenches T3 may extend in the third direction D3 from a planar perspective (e.g., in a plane defined by the first direction D1 and the third direction D3). The remaining mold structure MS may be spaced apart in the first direction D1 by the third trenches T3.

The third trench T3 may be formed by an etching process. A mask pattern having openings including portions corresponding to the plurality of third trenches T3 may be formed, and the mold structure MS may be anisotropically etched using the mask pattern as an etch mask. For example, the third trenches T3 may be formed by an etching process having an etch selectivity between the sacrificial films 10 and the semiconductor films 20 and the first insulating layers 30 and the preliminary supporter layers 300. For instance, the sacrificial films 10 and semiconductor films 20 may be etched to form the third trenches T3. The first insulating layers 30 and the preliminary supporter layers 300 may remain (e.g., may be relatively unetched) by the etching process. In one or more embodiments, the upper surface 100_1 of the substrate 100 below each of the plurality of third trenches T3 may be recessed by over-etching during the etching process.

The third trench T3 may expose side surfaces of the sacrificial films 10 and the semiconductor films 20. The sacrificial films 10 may be selectively removed through the third trench T3. As an example, the sacrificial films 10 may be removed by isotropic etching. As the sacrificial films 10 are removed, horizontal regions HS may be formed between adjacent semiconductor films 20 in the second direction D2. The semiconductor films 20 may be supported in a state of being spaced apart from each other by the first insulating layers 30 and the preliminary supporter layers 300.

A thickness of the horizontal regions HS in the second direction D2 may be substantially the same as a thickness of each of the sacrificial films 10. That is, a distance in the second direction D2 between mutually adjacent semiconductor films 20 may be substantially the same as the thickness of each of the sacrificial films 10. In one or more embodiments, an expansion process for expanding the horizontal regions HS may be performed. That is, a thickness of the semiconductor films 20 may be reduced. Accordingly, the semiconductor patterns SP (see FIG. 3) may be formed.

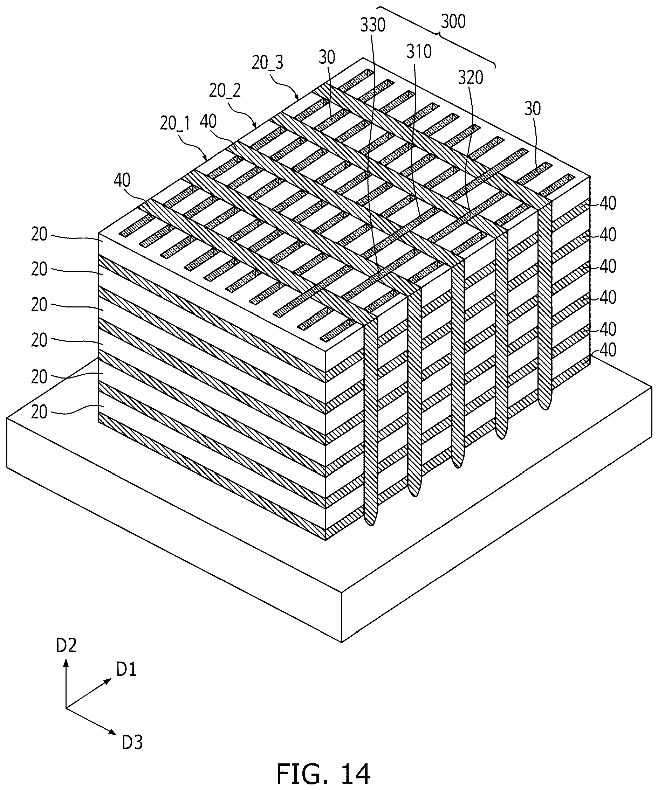

Referring to FIG. 14, second insulating layers 40 may be formed inside the third trench T3 and in the horizontal regions HS (see FIG. 13).

In a semiconductor device according to a comparative example, as a result of omitting the preliminary supporter layers 300, stress may be generated in the remaining semiconductor films 20 while forming the second insulating layers 40. As described above, after forming the third trench T3, the semiconductor films 20 may have a structure spaced apart in the first direction D1. Accordingly, bending may occur from a lower part to an upper part of the semiconductor films 20. For example, a pulling force may be generated between the semiconductor films 20 located on both sides of the third trench T3. In this case, a part of the semiconductor films 20 located on both sides of the third trench T3 may be bent in a direction in which the upper ends thereof become closer to each other. Due to this, a problem may occur in which the semiconductor patterns, etc. of the semiconductor device according to the comparative example in which the preliminary supporter layers 300 are omitted are bent. The risk of bending (e.g., warpage) can increase as the height of the stack of semiconductor films 20 is increased.

The preliminary supporter layers 300 of the semiconductor device according to example embodiments may support a part of the adjacent mold structure MS in the first direction D1. For example, the first preliminary supporter layer 310 may support a first semiconductor film stack 20_1 and a second semiconductor film stack 20_2. The first preliminary supporter layer 310 may mitigate or prevent deformation that may occur in the first semiconductor film stack 20_1 and the second semiconductor film stack 20_2. As another example, a second preliminary supporter layer 320 may support the second semiconductor film stack 20_2 and a third semiconductor film stack 20_3. The second preliminary supporter layer 320 may mitigate or prevent deformation that may occur in the second semiconductor film stack 20_2 and the third semiconductor film stack 20_3.

While the preliminary supporter layers 300 support the remaining semiconductor films 20, the second insulating layers 40 may be formed to fill the third trench T3 and the horizontal regions HS. The second insulating layers 40 may include at least one of silicon oxide, silicon oxynitride, etc. The second insulating layers 40 may be formed by depositing an insulating film to fill the third trench T3 and the horizontal regions HS, and planarizing the insulating film.

The second insulating layers 40 may extend in the third direction D3 from a planar perspective (e.g., in a plane defined by the first direction D1 and the third direction D3). Each of the second insulating layers 40 may be disposed to be spaced apart from each other in the first direction D1. The second insulating layers 40 may be separated in the third direction D3 by the preliminary supporter layers 300. For example, each of the first preliminary supporter layer 310, the second preliminary supporter layer 320, and the third preliminary supporter layer 330 may separate at least one of the second insulating layers 40 in the third direction D3.

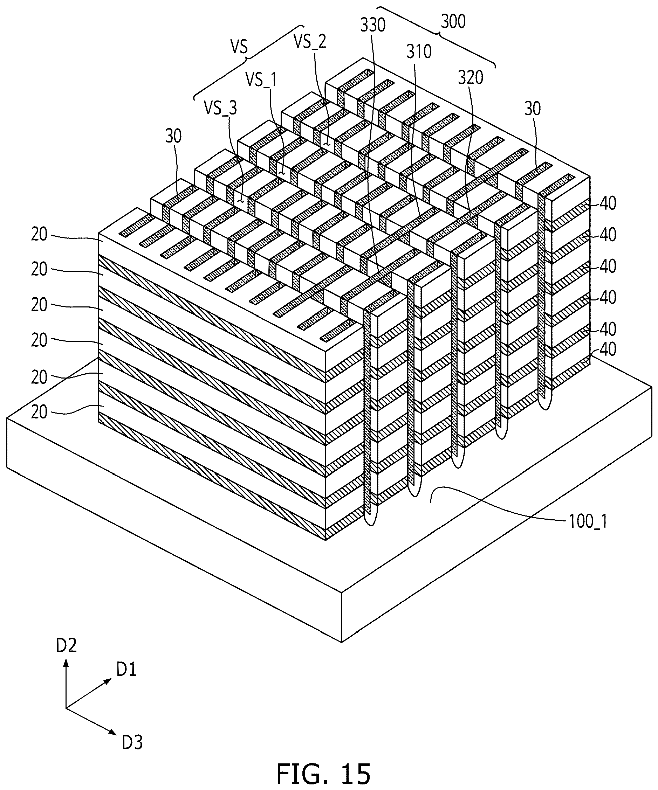

Referring to FIG. 15, a part of the first insulating layers 30 and the second insulating layers 40 may be removed. While the first insulating layers 30 and the second insulating layers 40 are removed, the preliminary supporter layer 300 may not be removed. As the second insulating layers 40 are removed, vertical regions VS may be formed. For example, a vertical region overlapping with the first preliminary supporter layer 310 may be referred to as a first vertical region VS_1, a vertical region overlapping with the second preliminary supporter layer 320 may be referred to as a second vertical region VS_2, and a vertical region overlapping with the third preliminary supporter layer 330 may be referred to as a third vertical region VS_3.

A capacitor structure CAP (see FIG. 2) may be formed in the first vertical region VS1. A bit line BL (see FIG. 2) may be formed in the second vertical region VS2 and the third vertical region VS3. In one or more embodiments, the second vertical region VS2 and the third vertical region VS3 may include a region where a part of the first insulating layers 30 is removed. For example, a part of the first insulating layers 30 may be laterally recessed in the first direction D1. The semiconductor films 20 may protrude from the remaining second insulating layers 40. A conductive material may be deposited on the protruding semiconductor films 20 to form a word line.

Hereinafter, for convenience of explanation, a description will be made focusing on a configuration different from the above-described content.

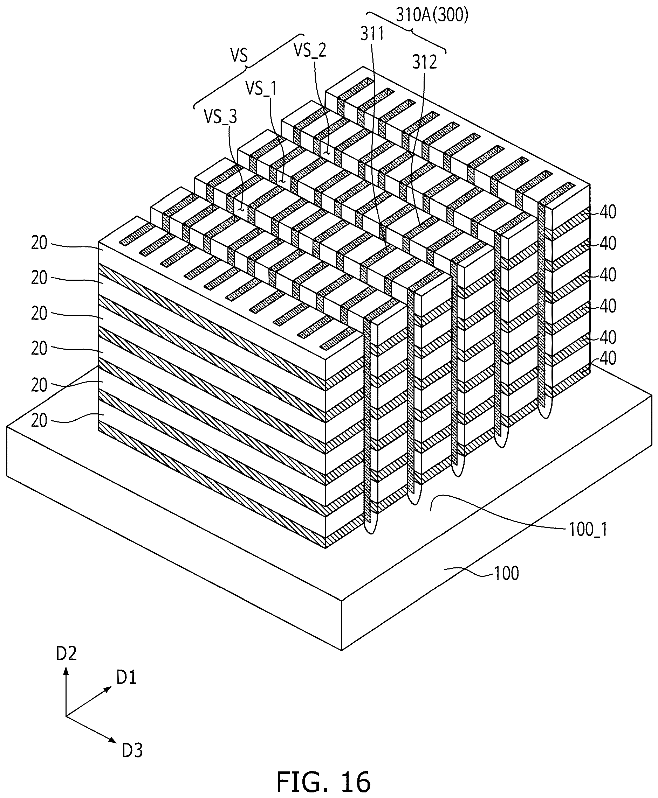

Referring to FIG. 16, unlike the example of FIG. 15, a part of the preliminary supporter layers 300 and the second insulating layers 40 may be removed together. For example, the preliminary supporter layers 300 and the second insulating layers 40 may be removed by an anisotropic etching process. Accordingly, each of the preliminary supporter layers 300 of FIG. 14 may be separated from each other in the first direction D1. Specifically, a first preliminary supporter layer 310A may be separated into a first portion 311 and a second portion 312.

Thereafter, a capacitor structure and a bit line may be formed in the vertical regions VS. For example, in a subsequent process, the capacitor structure and the bit line may be formed to be alternately disposed along the first direction D1 in the vertical regions VS. For example, the capacitor structure may be located between the first portion 311 and the second portion 312.

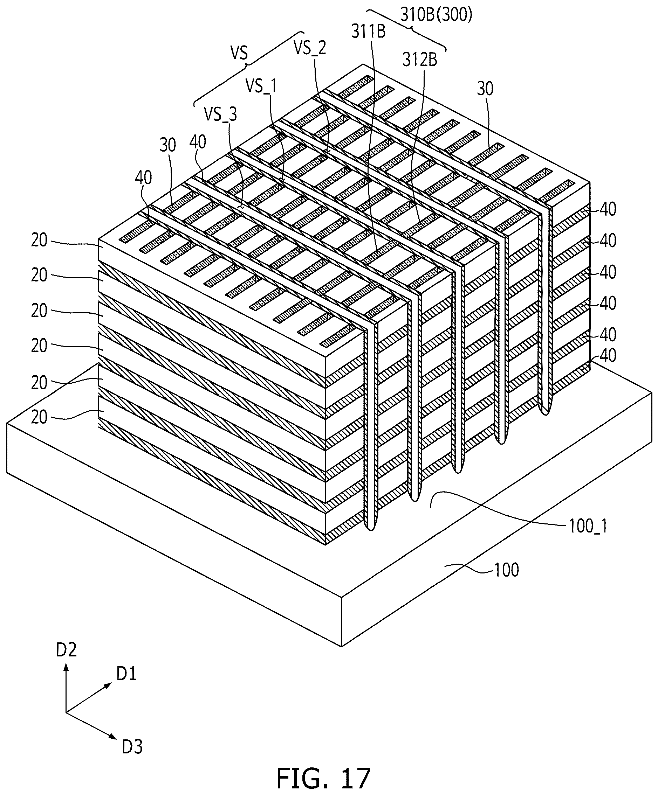

Referring to FIG. 17, unlike the example of FIG. 15, a part of the preliminary supporter layers 300 and a part of the second insulating layers 40 may be removed together. For example, a part of the preliminary supporter layers 300 and a part of the second insulating layers 40 may be removed by an anisotropic etching process. As the part of the preliminary supporter layers 300 and the part of the second insulating layers 40 are removed, vertical regions VS may be formed. A part of the second insulating layers 40 may remain without being removed. Accordingly, each of the preliminary supporter layers 300 may be separated from each other in the first direction D1. Specifically, a first preliminary supporter layer 310 may be separated into a first portion 311B and a second portion 312B.

A part of the first portion 311B and a part of the second portion 312B may overlap with the remaining second insulating layers 40 in the third direction D3. The first portion 311B and the second portion 312B may have a longer length in the first direction D1 than the first insulating layers 30. The first portion 311B and the second portion 312B may have a longer length in the first direction D1 compared to the first portion 311 and the second portion 312 of FIG. 16. The first portion 311B and the second portion 312B may have a shape protruding from the semiconductor films 20 in the first direction D1.

Thereafter, a capacitor structure and a bit line may be formed in the vertical regions VS. For example, in a subsequent process, the capacitor structure and the bit line may be formed to be alternately disposed along the first direction D1 in the vertical regions VS. For example, the capacitor structure may be located between the first portion 311B and the second portion 312B. The first portion 311B and the second portion 312B may have a shape protruding in the first direction D1 from a bottom electrode of a capacitor structure to be formed later.

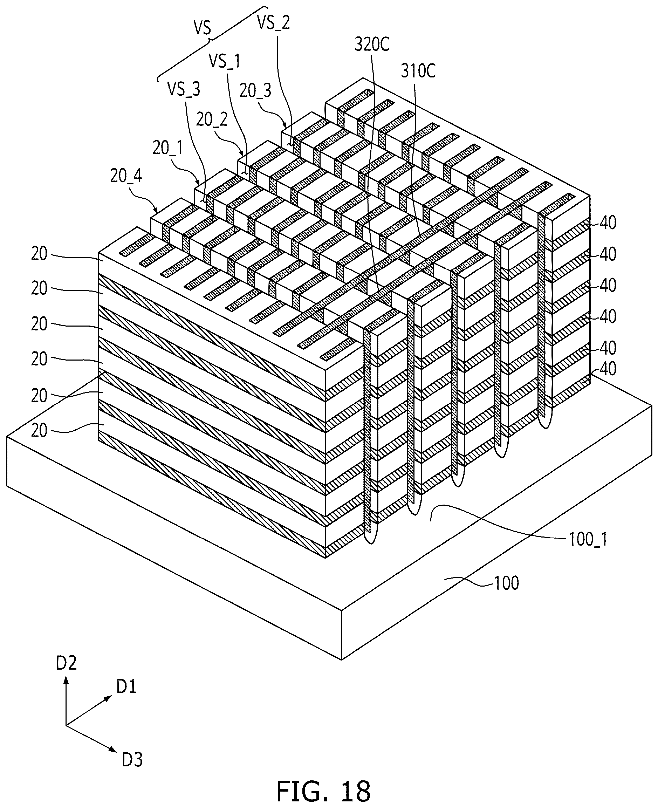

Referring to FIG. 18, unlike the example of FIG. 15, a first preliminary supporter layer 310C and a second preliminary supporter layer 320C may support three or more semiconductor film stacks spaced apart in the first direction D1. That is, the first preliminary supporter layer 310C and the second preliminary supporter layer 320C may support three or more groups of semiconductor films 20. For example, the first preliminary supporter layer 310C and the second preliminary supporter layer 320C may support first to fourth semiconductor film stacks 20_1-20_4. In one or more embodiments, the number of semiconductor film stacks that each of the first preliminary supporter layer 310C and the second preliminary supporter layer 320C can support may be variously changed depending on the length of the first preliminary supporter layer 310C and the second preliminary supporter layer 320C in the first direction D1.

The first preliminary supporter layer 310C and the second preliminary supporter layer 320C may be formed by depositing an insulating material inside the second trenches T2 (see FIG. 11) and planarizing the insulating material. The second trenches T2 may have a shape in which three or more first trenches T1 (see FIG. 11) spaced apart in the first direction D1 are merged. Each of the first preliminary supporter layer 310C and the second preliminary supporter layer 320C may overlap with all of the first vertical region VS_1, the second vertical region VS_2, and the third vertical region VS_3. Each of the first preliminary supporter layer 310C and the second preliminary supporter layer 320C may not be separated by the first vertical region VS_1, the second vertical region VS_2, and the third vertical region VS_3.

The first preliminary supporter layer 310C and the second preliminary supporter layer 320C may be spaced apart from each other in the third direction D3. Although a length of a long axis of the first preliminary supporter layer 310C and a length of a long axis of the second preliminary supporter layer 320C are shown to be the same, embodiments of the present disclosure are not limited thereto. In addition, the number and location of preliminary supporter layers are not limited thereto and may be provided in various numbers and locations.

According to one or more embodiments of the present disclosure, a method for manufacturing a semiconductor device includes forming a mold structure in which sacrificial films and semiconductor films are alternately stacked on an upper surface of a substrate, forming a plurality of first trenches and a plurality of second trenches in the mold structure, the plurality of first trenches and the plurality of second trenches penetrating the mold structure in a second direction perpendicular to a first direction so as to have a long axis in the first direction parallel to the upper surface of the substrate, forming a plurality of first insulating layers inside the plurality of first trenches, and forming a plurality of preliminary supporter layers inside the plurality of second trenches, wherein a length of a long axis of each of the plurality of second trenches may be longer than a length of a long axis of each of the plurality of first trenches.

According to one or more embodiments of the present disclosure, the length of the long axis of each of the plurality of second trenches may be longer than twice the length of the long axis of each of the plurality of first trenches.

According to one or more embodiments of the present disclosure, the method may further include forming third trenches in the mold structure, the plurality of third trenches penetrating the mold structure in the second direction and extending in a third direction perpendicular to each of the first direction and the second direction.

According to one or more embodiments of the present disclosure, the method may further include selectively removing the second insulating layers.

According to one or more embodiments of the present disclosure, the method may further include removing a part of the preliminary supporter layers and the second insulating layers.

According to one or more embodiments of the present disclosure, the method may further include removing a part of the preliminary supporter layers and a part of the second insulating layers to form a fourth trench penetrating the mold structure in the second direction and extending in a third direction perpendicular to each of the first direction and the second direction.

According to one or more embodiments of the present disclosure, the method may further include forming a capacitor structure in a region where the second insulating layers are removed.

While example embodiments of the present disclosure have been described and shown, the present disclosure is not limited thereto, and various modifications and changes may be made by those skilled in the art to which the present disclosure pertains within the technical scope of the present disclosure and the equivalent scope of the claims to be described below.

## Claims

1. A semiconductor device comprising:
a substrate (100);
first semiconductor patterns (SP1) extending in a first direction on an upper surface of the substrate (100), the first semiconductor patterns (SP1) being stacked on and spaced apart from each other in a second direction intersecting the first direction;
second semiconductor patterns (SP2) spaced apart from the first semiconductor patterns (SP1) in the first direction;
first word lines (WL1) extending in a third direction and surrounding each of the first semiconductor patterns (SP1), the third direction intersecting each of the first direction and the second direction;
second word lines (WL2) extending in the third direction and surrounding each of the second semiconductor patterns (SP2);
a capacitor structure (CAP) comprising:
first bottom electrodes (BE1) contacting a first surface of the first semiconductor patterns (SP1);
second bottom electrodes (BE2) contacting a first surface of the second semiconductor patterns (SP2); and
a dielectric layer (CIL) covering the first bottom electrodes (BE1) and the second bottom electrodes (BE2); and
a support structure (200) on the upper surface of the substrate and comprising a first supporter layer (210) extending in the second direction,
wherein the first supporter layer (210) comprises:
a first portion (211) on a side surface of each of the first word lines (WL1) and partially overlapping the first bottom electrodes (BE1) in the third direction; and
a second portion (212) on a side surface of each of the second word lines (WL2) and partially overlapping the second bottom electrodes (BE2) in the third direction.

2. The semiconductor device as claimed in claim 1, wherein the first supporter layer (210) further comprises a connection portion (213) between and connecting the first portion (211) and the second portion (212).

3. The semiconductor device as claimed in claim 2, wherein the first supporter layer (210) further comprises:
a first extension portion (214) extending from the first portion (211) in a direction away from the second portion (212); and
a second extension portion (215) extending from the second portion (212) in a direction away from the first portion (211).

4. The semiconductor device as claimed in claim 2 or claim 3, wherein, from a planar perspective, a part of the dielectric layer (CIL) extends in the first direction on the connection portion (213).

5. The semiconductor device as claimed in any of claims 2-4, wherein the capacitor structure (CAP) further comprises:
a top electrode (UE) covering the dielectric layer (CIL); and
a plate electrode (PE) covering the top electrode (UE), and
wherein a part of the top electrode (UE) and a part of the plate electrode (PE) overlap the connection portion (213) in the third direction.

6. The semiconductor device as claimed in claim 1, further comprising:
third semiconductor patterns (SP3) spaced apart from the first semiconductor patterns (SP1) in the third direction; and
fourth semiconductor patterns (SP4) spaced apart from the second semiconductor patterns (SP2) in the third direction,
wherein the capacitor structure (CAP) further comprises:
third bottom electrodes (BE3) connected to the third semiconductor patterns (SP3) and spaced apart from the first bottom electrodes (BE1) in the third direction; and
fourth bottom electrodes (BE4) connected to the fourth semiconductor patterns (SP4) and spaced apart from the second bottom electrodes (SP2) in the third direction, and
wherein the third bottom electrodes (BE3) and the fourth bottom electrodes (BE4) contact a first side surface of the first supporter layer (210).

7. The semiconductor device as claimed in claim 6, wherein a part of the dielectric layer (CIL) is between the third bottom electrodes (BE3) and the fourth bottom electrodes (BE4) in the first direction.

8. The semiconductor device as claimed in claim 6 or claim 7, further comprising:
fifth semiconductor patterns (SP5) spaced apart from the third semiconductor patterns (SP3) in the third direction; and
sixth semiconductor patterns (SP6) spaced apart from the fourth semiconductor patterns (SP4) in the third direction,
wherein the capacitor structure (CAP) further comprises:
fifth bottom electrodes (BE5) connected to the fifth semiconductor patterns (SP5) and spaced apart from the third bottom electrodes (BE3) in the third direction; and
sixth bottom electrodes (BE6) connected to the sixth semiconductor patterns (SP6) and spaced apart from the fourth bottom electrodes (BE4) in the third direction, and
wherein the fifth bottom electrodes (BE5) and the sixth bottom electrodes (BE6) contact a second side surface of the first supporter layer (210) opposite the first side surface of the first supporter layer (210).

9. The semiconductor device as claimed in claim 8, wherein a part of the first portion (211) protrudes from the third bottom electrodes (BE3) and the fifth bottom electrodes (BE5) toward the second portion (212),
wherein a part of the second portion (212) protrudes from the fourth bottom electrodes (BE4) and the sixth bottom electrodes (BE6) toward the first portion (211), and
wherein a first distance in the first direction between the first portion (211) and the second portion (212) is smaller than a second distance in the first direction between the third bottom electrodes (BE3) and the fourth bottom electrodes (BE4).

10. The semiconductor device as claimed in any of claims 1 or 6-9, wherein a part of the capacitor structure (CAP) is between the first portion (211) and the second portion (212).

11. The semiconductor device as claimed in claim 10, wherein a part of the dielectric layer (CIL) extends in the third direction on the first portion (211) and the second portion (212).

12. The semiconductor device as claimed in any preceding claim, further comprising:
a first bit line (BL1) contacting a second surface of the first semiconductor patterns (SP1) opposite the first surface of the first semiconductor patterns (SP1); and
a second bit line (BL2) contacting a second surface of the second semiconductor patterns (SP2) opposite the first surface of the second semiconductor patterns (SP2),
wherein the support structure (210) further comprises:
a second supporter layer (220) partially overlapping the second bit line (BL2) in the third direction; and
a third supporter layer (230) partially overlapping the first bit line (BL1) in the third direction, and
wherein each of the second supporter layer (220) and the third supporter layer (230) is spaced apart from the first supporter layer (210) in the first direction and the third direction.

13. The semiconductor device as claimed in claim 12, wherein the second supporter layer (220) and the third supporter layer (230) are spaced apart in the first direction.

14. The semiconductor device as claimed in any preceding claim, wherein the first semiconductor patterns (SP1) are disposed in a cell region, and the support structure (210) is disposed in a dummy region.

15. The semiconductor device as claimed in any preceding claim, wherein the support structure (210) comprises silicon nitride.
